Europäisches Patentamt

European Patent Office

Office européen des brevets

(19)

(11) Veröffentlichungsnummer: **0 124 705**
**B1**

(12) # EUROPÄISCHE PATENTSCHRIFT

(45) Veröffentlichungstag der Patentschrift:
**07.10.87**

(21) Anmeldenummer: **84102307.0**

(22) Anmeldetag: **03.03.84**

(51) Int. Cl.⁴: **H 01 L 23/04**

(54) **Halbleiterelement mit Halbleitertablette und ringförmigem Isolierkörper.**

(30) Priorität: **11.03.83 DE 3308661**

(43) Veröffentlichungstag der Anmeldung:
**14.11.84 Patentblatt 84/46**

(45) Bekanntmachung des Hinweises auf die Patenterteilung:
**07.10.87 Patentblatt 87/41**

(84) Benannte Vertragsstaaten:
**CH DE FR GB IT LI SE**

(56) Entgegenhaltungen:
**EP - A - 0 009 152**
**DE - A - 3 006 023**
**DE - B - 1 614 603**
**GB - A - 2 074 373**

(73) Patentinhaber: **SEMIKRON Elektronik GmbH,**
**Sigmundstrasse 200, D-8500 Nürnberg 82 (DE)**

(72) Erfinder: **Creutz, Helmut, Parkstrasse 14,**
**D-8502 Zirndorf (DE)**

## Beschreibung

Die Erfindung betrifft ein Halbleiterelement.

Bei Stromrichtern mit sehr hoher Strombelastbarkeit der Einzelelemente sind bevorzugt scheibenförmige, als Scheibenzellen bezeichnete Halbleiterbauelemente vorgesehen, die druckkontaktiert zwischen Kühlbauteilen angeordnet sind.

Bekannte Scheibenzellen bestehen aus einem aus scheibenförmigem und weiterhin als Halbleitertablette bezeichneten Halbleiterkörpern und aus daran angrenzenden Kontaktscheiben gebildeten Stapel, der in einem Gehäuse aus metallischen Deckplatten und aus einem zwischen diesen dicht befestigten Isolierstoffring untergebracht ist. Ein solcher Aufbau erfordert einen hohen Aufwand an Material und an Verfahrenstechnik. Die dichte Unterbringung des Stapels zur Vermeidung schädlicher Umgebungseinflüsse auf das elektrische Verhalten macht die unerwünschte Materialbindung von teueren Einzelteilen für das Gehäuse und für den Gesamtaufbau bei der Lagerung fertiger Scheibenzellen notwendig. Schliesslich entstehen erhebliche Verluste, wenn solche kostenintensive Bauelemente aufgrund unzulässig veränderter Daten nach Lagerung verworfen oder aufgearbeitet werden müssen.

Es sind auch billigere Bauformen von im wesentlichen scheibenförmigen Halbleiterbauelementen bekannt, bei welchen die Teile des Stapels unter Aussparung der Kontaktflächen mit einem Schrumpfschlauch umhüllt und zusammengehalten sind.

Bei anderen Aufbauten ist nach dem Prinzip der Scheibenzellen ein Stapel aus Halbleitertablette und Kontaktteilen in Aussparungen eines Isolierstoffkörpers untergebracht, der zusammen mit Strom- und/oder Wärmeleitungselementen und zwischengefügten Dichtungskörpern ein Gehäuse bildet. Die bekannten Anordnungen sind jedoch insbesondere bei hohen Betriebs- oder Verfahrenstemperaturen nicht ausreichend mechanisch stabil und ausserdem nicht im gewünschten Masse langzeitlagerfähig.

Ein Halbleiterbauelement gmeäss dem ersten Teil des Patentanspruchs 1 ist aus EP-A 0 009 152 bekannt.

Der Erfindung lag die Aufgabe zugrunde, einen Aufbau zu schaffen, der ohne Bindung teurer Bauteile ein elektrisch geprüftes, besonders wirtschaftliches, langzeitlagerfähiges sowie einen einfachen Zusammenbau begünstigendes Einzelelement darstellt, in beliebiger Weise den Einbau sowohl in eine herkömmliche Scheibenzelle als auch in Baueinheiten mit zwei oder mehr Halbleiterbauelementen ermöglicht sowie zu einem selbständigen Bauelement für unterschiedliche Anordnungen vervollständigt werden kann.

Diese Aufgabe wird erfindungsgemäss gelöst durch die Merkmale des Anspruchs 1.

Vorteilhafte Weiterbildungen des Gegenstandes der Erfindung sind in den Unteransprüchen 2 bis 20 offenbart.

Anhand der in den Figuren 1 bis 6 dargestellten Ausführungsbeispiele wird der Gegenstand der Erfindung aufgezeigt und erläutert. Figur 1 zeigt teilweise im Querschnitt und teilweise perspektivisch die grundsätzliche Ausbildung und räumliche Zuordnung seiner Bauteile. In Figur 2 ist in Draufsicht und in den Figuren 3a und 3b sind im Querschnitt Formen des einen Bauteils dargestellt. Figur 4 zeigt in Vorderansicht und im Ausschnitt die Enden einer anderen Form des einen Bauteils. Die Figuren 5 und 6 zeigen die Anwendung des Gegenstandes der Erfindung bei einer im Querschnitt bzw. in teilweiser Draufsicht dargestellten Ausführungsform eines Halbleiterbauelements.

Für gleiche Teile sind in allen Figuren gleiche Bezeichnungen gewählt.

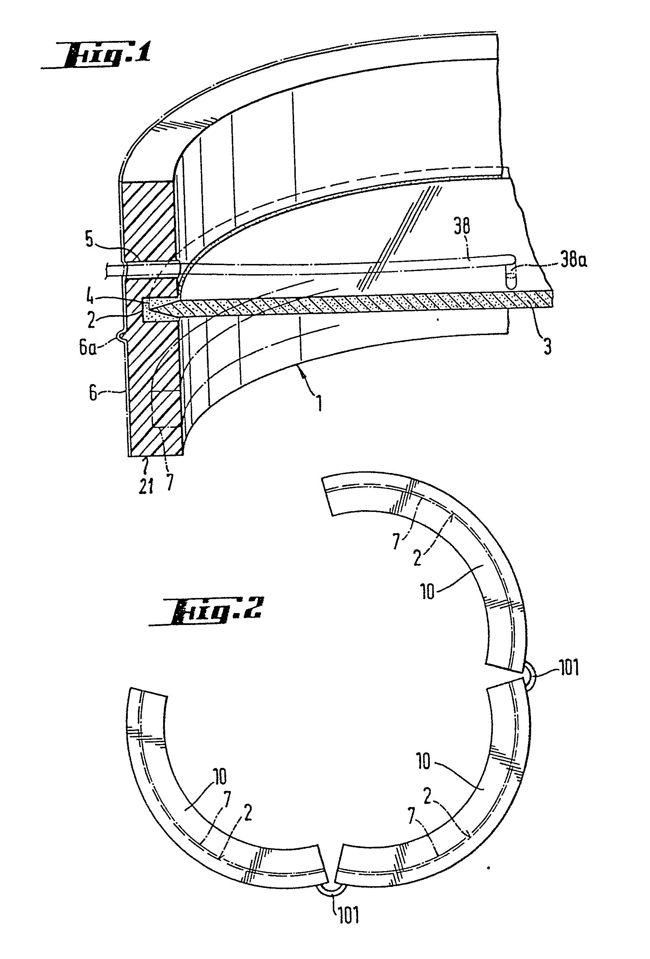

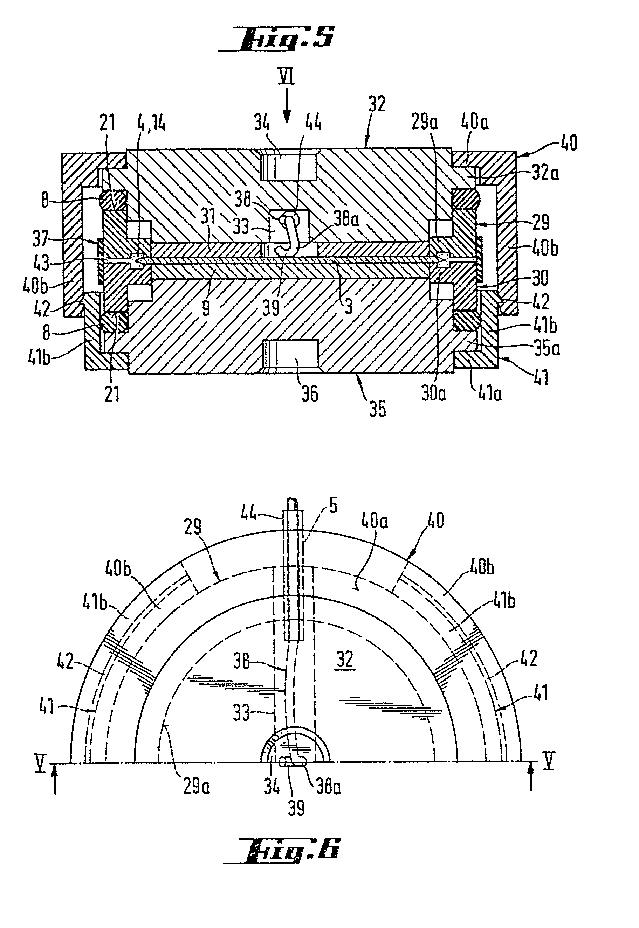

Bei einem Aufbau nach Figur 1 ist eine Halbleitertablette 3 an ihrem Umfang von einem ringförmigen Isolierkörper 1 umschlossen. Letzterer weist an seiner inneren Umfangsfläche eine in sich geschlossene Vertiefung 2 auf. Diese ist im wesentlichen der Form der Randzone der Halbleitertablette 3 angepasst bemessen und z.B. rillenförmig ausgebildet. Erfindungsgemäss ragt die Randzone, die zur Erzielung hoher Sperrfähigkeit z.B. im Bereich des Austritts des pn-Übergangs im spitzen Winkel zur pn-Übergangsfläche verläuft und mit einer nicht dargestellten Oberflächenschutzschicht versehen ist, ganz in die Vertiefung 2 hinein und taucht in eine in der Vertiefung 2 angebrachte Füllung aus einer passivierenden und stabilisierenden Substanz 4 ein. Zusätzlich kann der Isolierkörper 1 zur Justierung der Halbleitertablette in axialer Richtung vorgesehen sein. Zu diesem Zweck ist die Vertiefung 2 z.B. an ihren Seitenwänden zur inneren Umfangsfläche hin zu kleinerer lichter Weite abgesetzt ausgebildet, wie dies in Figur 3a am inneren Abschnitt des Ansatzes 11a erkennbar ist. Die Halbleitertablette 3 liegt dann wenigstens an einer Fläche an dem entsprechenden Flächenabschnitt der Vertiefung 2 an.

Zur konzentrischen Anordnung von Kontaktteilen an der Halbleitertablette 3 wie Kontaktronden aus Molybdän oder Druckstücken aus Kupfer, jedoch unter Berücksichtigung einer Verbindung der Druckstücke mit Anschlussteilen wie Stromschienen, weist der Isolierkörper 1 eine bestimmte Bauhöhe auf. Ferner können an der Innenmantelfläche zwischen Vertiefung 2 und jeweiliger Stirnfläche zur Aufnahme je eines Dichtungskörpers Aussparungen zum dichten Einschluss der Halbleitertablette 3 vorgesehen sein, wie dies in Figur 1 mit unterbrochenen Linien gezeigt ist.

Zur Erhöhung der Spannungsüberschlagsfestigkeit kann an der Aussenmantelfäche des Isolierkörpers 1 ein Überzug, z.B. aus einem Schrumpfschlauch und z.B. mit wenigstens einer wulstförmigen Erhebung 6a, angebracht sein. Dies ist in der Figur mit unterbrochenen Linien dargestellt.

Die Halbleitertablette 3 weist eine Folge von schichtförmigen Zonen unterschiedlichen Leitungstyps mit einem oder mehreren pn-Übergängen auf. Bei Verwendung einer Halbleitertablette mit vier Zonen abwechselnd entgegengesetzten Leitungstyps für steuerbare Gleichrichter verläuft der Steuerstromleiter 38 (vergleiche Figur 6) unmittelbar in der mit unterbrochenen Linien dargestellten Durchbohrung 5 oder aber durch eine darin angebrachte, nicht dargestellte rohrförmige Durchführung. Erfindungsgemäss ist dann die Steuerelektrode durch Druck mittels Federkraft kontaktiert. Dazu ist der Steuerstromleiter gemäss Figur 5 und 6 mit zugehöriger Beschreibung besonders ausgebildet und angeordnet.

Die vorgesehene, passivierende und stabilisierende Substanz 4 hat vorteilhaft Klebewirkung gegenüber dem Material des Isolierkörpers 1 und gegenüber dem Halbleitermaterial. Dadurch ist in überraschend einfacher Weise eine einwandfrei abgedeckte Randfläche der Halbleitertablette 3 im Bereich des Austritts des oder der pn-Übergänge gewährleistet. Als geeignet haben sich Substanzen aus der Gruppe der Silikone erwiesen. Mit handelsüblichen Silikonkautschuksorten wurden günstige Ergebnisse erzielt.

Der Isolierkörper 1 kann aus Keramik oder aus einem hochtemperaturbeständigen Thermoplasten bestehen, der bei allen auftretenden Betriebstemperaturen formstabil bleibt und keine Entgasung zeigt. Z.B. wurden mit den Substanzen Polysulfon, Polyäthersulfon oder Polysulfonätherkethon vorteilhafte Ergebnisse erzielt.

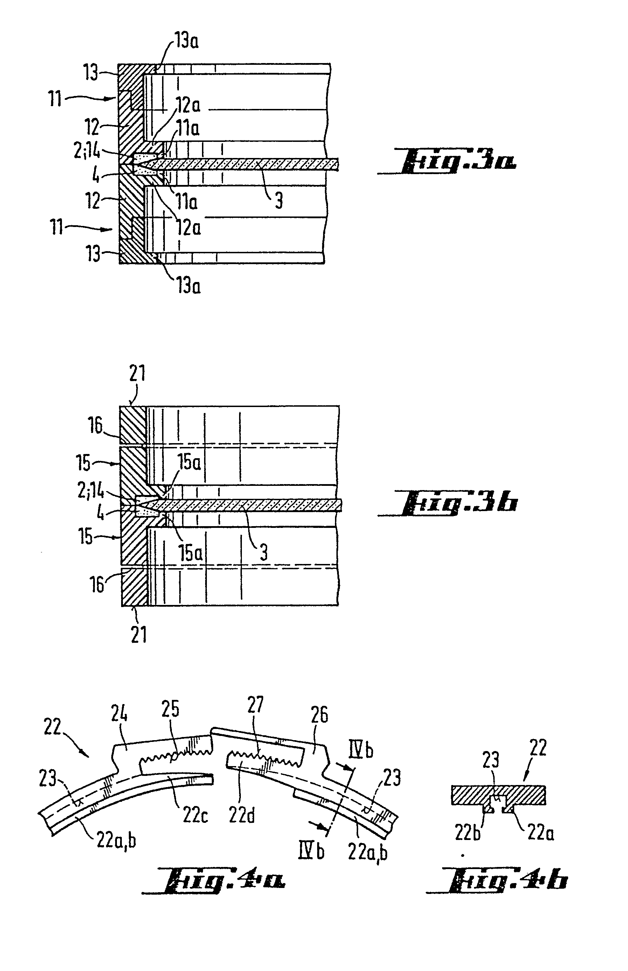

Zum Einbringen der Halbleitertablette 3 in die Vertiefung 2 des dargestellten Isolierkörpers 1 ist dieser aus wenigstens zwei Teilen axial oder radial zusammenfügbar ausgebildet. So kann der Isolierkörper aus zwei Ringstücken 10 bestehen. Als vorteilhaft hat sich die Unterteilung in n Ringstücke mit n gleich oder grösser 3 erwiesen, wie dies in Figur 2 dargestellt ist. Zur Verbindung von Ringstücken 10 aus Kunststoff können biegsame, jeweils an der Aussenmantelfläche angebrachte Fortsätze 101 dienen. Bei n Ringstücken ergibt sich dann mit Hilfe von n-1 Fortsätzen eine kettenförmige Anordnung, wie sie aus Figur 2 ersichtlich ist. Zur Herstellung des Isolierkörpers 1 sind die Ringstücke durch Schweissen oder Kleben fest verbunden. Die Vertiefung 2 und die Aussparung 7 sind mit unterbrochenen Linien dargestellt.

Die Figuren 3a und 3b zeigen Bauformen des Isolierkörpers 1. Er besteht bei einer solchen gemäss Figur 3a aus zwei Teilringen 11, die an einem Abschnitt ihrer gegenüberliegenden Stirnflächen axial verbunden sind. Eine solche Verbindung ist nicht dargestellt, jedoch ist aus der räumlichen aufbaugerechten Gegenüberstellung von Teilringen an deren Symmetrieebene auch bei unterschiedlicher Formgebung die Verbindung gleicher Teilringe an dem vorgesehenen Stirnflächenabschnitt erkennbar.

Jeder Teilring 11 weist an seiner dem anderen zugewandten Stirnfläche eine nutenförmige Aussparung auf, die einen längeren Schenkel an der Aussenmantelfläche und einen kürzeren Schenkel an dem stufenförmig ausladenen Absatz 12a der Innenmantelfläche begrenzt. Die Stirnfläche des längeren Schenkels ist Verbindungsfläche der Teilringe, und die Stirnfläche des kürzeren Schenkels kann die Justierfläche für die Halbleitertablette 3 bilden. Die zwischen beiden Teilringen 11 gebildete Vertiefung 14 dient zur Aufnahme der passivierenden und stabilisierenden Substanz 4 und der Randzone der Halbleitertablette 3. Die Substanz 4 dient aufgrund ihrer Klebeeigenschaft gegenüber den angrenzenden Materialien gleichzeitig als Verbindungsmittel für die Teilringe 11.

Jeder Teilring 11 kann, um die aufgabengemässe Forderung nach universeller Anwendbarkeit zu erfüllen, zur Reduzierung der Bauhöhe des Halbleiterelements auf ein durch den Aufbau in genormte Scheibenzellengehäuse bestimmtes Mass, aus zwei zusammenfügbaren Teilringabschnitten 12 und 13 bestehen, die z.B. mit Hilfe entsprechender Profilgebung an ihren axialen Verbindungsflächen durch Zusammenstecken verbunden sind. Beim Einsatz in Scheibenzellengehäusen entfällt der Teilringabschnitt 13. Wird er im übrigen verwendet, kann er am freien Ende seiner Innenmantelfläche eine flanschförmige Ausladung 13a zum Einschluss eines Dichtungskörpers zwischen Teilring 11 und einer im Stapel mit der Halbleitertablette 3 befindlichen, nicht dargestellten Kontaktscheibe aufweisen.

Gemäss Figur 3b ist ein Teilring 15 des Isolierkörpers einstückig ausgebildet und weist zur Reduzierung der Bauhöhe für den oben genannten Einsatz in entsprechendem Abstand von der äusseren Stirnfläche eine Soll-Bruchstelle 16 auf. Der Ansatz 15a zur Justierung von Bauteilen entspricht im wesentlichen dem Ansatz 12a in Figur 3a. Jedoch ist seine axiale Ausdehnung bei einem Teilestapel für steuerbare Halbleiterbauelemente auf der Steuerelektrodenseite zur Beachtung unvermeidlicher Exzentrizitäten auf die Zentrierung einer Kontaktscheibe aus Molybdän beschränkt.

Bei einer weiteren vorteilhaften Ausgestaltung hat der Isolierkörper die Form eines bandförmigen Zentrierbauteils 22 mit sich überlappenden Enden 22c, 22d. Dessen Endabschnitte sind in Figur 4 dargestellt. Das dabei vorgesehene Profil des Isolierkörpers zur Umschliessung der Randzone der Halbleitertablette 3 und zur gleichzeitig vorgesehenen Justierung von Stapelteilen ist zusätzlich im Querschnitt gezeigt, um den Verlauf von Profilabschnitten bei Überlappung der Enden 22c, 22d erkennen zu lassen.

Die mechanisch stabile Verbindung der Enden ist durch gegenseitiges Feststellen mittels Einrasten hergestellt. Dazu dient je ein Klemmenstück, das aus einem Ende des Zentrierbauteils 22 und aus einem an dessen Aussenfläche angeformten, im wesentlichen L-förmigen Abschnitt 24, 26 gebildet ist. Die beiden Klemmenstücke sind in festgestelltem Zustand durch überlappendes Zusammenstecken aus der gezeigten Stellung und mit Hilfe von jeweils an ihrer mittleren der drei Anlageflächen angebrachten, ineinandergreifenden Einkerbungen 25, 27 arretiert. Der Verschluss ist wieder lösbar. Aus der Darstellung ist die jeweils sich verjüngende Profilgebung an beiden Enden 22c, 22d zur Erzielung einer durchgehenden Vertiefung zwischen den Ansätzen 22a, 22b erkennbar. Damit ist bei zusammengefügten Enden durch Aufeinandersetzen von sich zum Profil ergänzenden Abschnitten in jedem Längenteilchen die erfindungsgemässe Umschliessung der Halbleitertablette 3 gewährleistet.

Für Bauformen zum Einbau in herkömmlichen Scheibenzellengehäusen mit vorgegebenen Abmessungen kann ein Zentrierbauteil mit überlappenden Enden z.B. mit Hilfe von an sich aus vielen Zweigen der Technik bekannten, sogenannten Schlauchbindern hergestellt sein. Nach Herstellung einer festen Verbindung der Enden wird der Schlauchbinder entfernt.

Die Erfindung ist nicht auf die beschriebenen Beispiele beschränkt. So können die Enden des Zentrierbauteils 22 mit Ansätzen versehen sein, die einen einfachen und wenig ausladenden, sogenannten Schnappverschluss ermöglichen. Die Verschlussarten als solche sind nicht Gegenstand der Erfindung, vielmehr nur ihre Anwendung bei der mechanisch stabilen Umhüllung einer Halbleitertablette.

Eine vorteilhafte Verwendung des Gegenstandes der Erfindung mit weiteren Bauteilen zur Herstellung eines selbständigen Halbleiterbauelements zeigen die Figuren 5 und 6. Das erfindungsgemässe Halbleiterelement besteht aus der Halbleitertablette 3 und den Teilringen 29, 30. Diese weisen im wesentlichen L-förmiges Profil auf mit einem axialen Schenkel zur konzentrischen Justierung von als Druckstücken bezeichneten Kontaktteilen 32, 35 und mit einem radialen Schenkel 29a, 30a. Beide radialen Schenkel sind im Abstand spiegelbildlich zu einer Symmetrieebene angeordnet, die gleichzeitig die Mittelebene der Halbleitertablette 3 darstellt, und bilden eine durchgehende Vertiefung 43 zur Aufnahme der Randzone der Halbleitertablette 3. An der Aussenmantelfläche der Teilringe 29, 30 ist die Vertiefung mit einem beide Teilringe umfassenden, elastischen Überzug 37, beispielsweise einem Schrumpfschlauch, verschlossen. Zur Ausbildung der Vertiefung 43 kann die Stirnfläche der Teilringe 29, 30 entsprechend derjenigen bei Bauformen nach den Figuren 3a und 3b ausgestaltet sein. Der durch die Teilringe auf die Halbleitertablette zu deren Justierung ausgeübte Druck ist vergleichsweise zu dem im Bereich der Druckstücke bestehenden Kontaktdruck vernachlässigbar.

Im Anschluss an die Halbleitertablette 3 sind Kontaktplatten 9 und 31 aus Molybdän, letztere mit einer Öffnung für die Steuerelektrodenkontaktierung, angeordnet und durch die Teilringe 29, 30 justiert. Daran schliessen sich Druckstücke 32, 35 aus Kupfer an, wobei das erstere mit einer Aussparung 33 für die Steuerelektrodenzuleitung versehen ist. Beide Druckstücke sind durch die Teilringe konzentrisch zum Halbleiterelement angeordnet und bilden mit Hilfe von Dichtungskörpern 8 zwischen einem flanschförmigen Ansatz 32a, 35a an ihrer Mantelfläche und der jeweiligen Stirnseite der Teilringe mit diesen ein dichtes Gehäuse für das Halbleiterelement.

Zur gewünschten Halterung der gestapelten und justierten Teile als ein selbständiges Bauelement sind als Spannelemente bezeichnete Überwurfstücke 40, 41 vorgesehen. Die Spannelemente weisen becherartige Grundform auf und sind kappenförmig jeweils auf eines der Druckstücke aufgesetzt. Dazu ist das einer Bodenplatte ähnliche Basisteil 40, 41a jedes Spannelements als Ringscheibe ausgebildet, die jeweils auf der freien Oberfläche des flanschförmigen Ansatzes 32a, 35a aufliegt. Damit liegen die Kontaktflächen der Druckstücke 32, 35 frei. Die Wand der Spannelemente ist auf z.B. drei bogenförmige Wandabschnitte 40b, 41b gleicher Abmessungen und gleichen gegenseitigen Abstandes beschränkt. Die radiale Ausladung der Spannelemente ist für eine überlappende Anordnung am freien Ende der Wandabschnitte bemessen, und die Überlappungsflächen weisen entsprechende Einkerbungen 42 zum gegenseitigen Eingriff und zum Feststellen durch Einrasten auf. Diese Verbindung ist durch Drehen der Spannelemente lösbar, wozu die Wandabschnitte 40b, 41b beispielsgemäss jeweils im Abstand von maximal 61° angeordnet sind und eine einen Winkel von maximal 59° entsprechende Bogenlänge aufweisen.

Die Druckstücke 32, 35 sind an ihrer äusseren Kontaktfläche jeweils mit einer Justierbohrung 34 bzw. 36 versehen.

Die bei einem Halbleiterelement nach der Erfindung mit einem Halbleiterkörper mit Steuerelektrode erfindungsgemäss vorgesehene Druckkontaktierung ist in dem Anwendungsbeispiel der Figuren 5 und 6 ebenfalls aufgezeigt. Zur Kontaktierung der zentral angeordneten Steuerzone dient ein drahtförmiger Steuerstromleiter 38 aus einem Federmaterial, z.B. aus einem Federstahl. Der erste Abschnitt dieses Steuerstromleiters ist durch ein Rohrstück 44 des Isolierkörpers 29 (vergleiche Figur 6) geführt. Der zweite Abschnitt zwischen Rohrstück und Steuerelektrode der Halbleitertablette 3 verläuft in einer Ausnehmung 33 des Druckstücks 32 und ist zur Erzielung einer Federkraft für die Druckkontaktierung bogenförmig nach Art einer Blattfeder ausgebildet. Der dritte Abschnitt, zur Anordnung auf der Steuerelektrode vorgesehen und als Kontaktbügel bezeichnet, weist am freien Ende eine Krümmung 38a in Form eines Hakens oder einer Öse auf und ist am Ansatz der Krümmung in eine Ebene senkrecht zur Steuerstromleiterachse abgewinkelt. Damit ist der Kontaktbügel um diese Achse drehbar angeordnet, und die Krümmung stellt ein Kurvenstück zur Gleitbewegung des Bügels auf der Halbleitertablette dar. Das Kurvenstück kann Kreisbogenform aufweisen mit einer Länge von wenigstens einem Halbkreis oder aus mehreren Teilen mit unterschiedlichem Krümmungsmittelpunkt oder aus einem im wesentlichen z.B. nur senkrecht abgewinkelten, gestreckten Abschnitt mit abschliessend gebogenem Endabschnitt bestehen.

Durch Drehen der Steuerstromleiters 38 als der Drehachse des Kontaktbügels 38a wird diese mit Hilfe des Kurvenstücks gegen die Federkraft des zweiten Abschnitts aus einer Anfangsstellung mit kürzestem Abstand in die Endlage mit grösstem Abstand zur Halbleitertablette bewegt. Damit wird die Federkraft auf einen Betrag mit vorgesehenen Bereich von ca. 200 N bis 300 N erhöht.

Die Ausnehmung 33 des Druckstücks 32 ist der zur Anordnung des Kontaktbügels 38a vorgesehenen Aussparung in der Kontaktplatte 31 aus Molybdän angepasst.

Zur gewünschten flächenhaften Auflge auf der Halbleitertablette ist der Kontaktbügel 38a an der entsprechenden Stelle seiner betriebsbereiten Position plan ausgebildet (39).

Mit der aufgezeigten Umhüllung liegt ein als selbständiges Bauelement einsetzbarer Aufbau vor.

Das erfindungsgemässe Halbleiterelement kann gleichermassen vorteilhaft auch zwischen Kühlelementen angeordnet sein, die gleichzeitig als Druckstücke dienen und entsprechend ausgebildet sind. So können plattenförmige Kühlelemente tafelförmige Ansätze aufweisen, die an den aus Halbleitertablette und angrenzenden Kontaktscheiben aus Molybdän gebildeten Stapel angrenzend angebracht sind.

Die Vorteile des Gegenstandes der Erfindung bestehen in der weitestgehenden Austauschbarkeit sämtlicher mit der Halbleitertablette zu kontaktierenden Bauteile, in der Gewährleistung stabiler elektrischer Eigenschaften der Halbleitertablette unabhängig von Kontaktbauteilen, Lagerung und Anwendung, in erheblichen Kosteneinsparungen gegenüber bekannten Anordnungen und in seiner unbegrenzten Verwendbarkeit bei generell einfachstem Zusammenbau mit Kontakt- und Kühlelementen.

**Patentansprüche**

1. Halbleiterelement, bei dem eine Halbleitertablette (3) mit Steuerelektrode von einem mehrteiligen Isolierstoffkörper (1) ringförmig umschlossen ist, der Isolierstoffkörper an seiner Innenmantelfläche eine in sich geschlossene Vertiefung (2, 14, 23, 43) aufweist, welche die Randzone der Halbleitertablette umschliesst, und bei dem die Steuerelektrode mittels Federdruck mit einer Steuerstromleiter (38) kontaktiert ist, dadurch gekennzeichnet, dass
- die Vertiefung (2, 14, 23, 43) im wesentlichen der Form der Tablettenrandzone angepasst und mit einer passivierenden und stabilisierenden Substanz (4) gefüllt ist,
- die Tablettenrandzone in die Substanz der Vertiefung eingetaucht ist,
- die Substanz Klebeeigenschaft gegenüber der Halbleitertablette (3) und dem Isolierstoffkörper (1) aufweist, und
- der Steuerstromleiter (38) durch den Isolierstoffkörper geführt, angrenzend als Federkörper ausgebildet und mit seinem Endabschnitt unter Druck auf der Steuerelektrode aufgesetzt ist.

2. Halbleiterelement nach Anspruch 1, dadurch gekennzeichnet, dass der Isolierkörper (1) aus n Ringstücken (10) für n gleich oder grösser 3 besteht.

3. Halbleiterelement nach Anspruch 2, dadurch gekennzeichnet, dass die n Ringstücke (10) über n-1 biegsame, jeweils an der Aussenfläche gebildete Fortsätze (101) kettenförmig verbunden sind.

4. Halbleiterelement nach Anspruch 1, dadurch gekennzeichnet, dass als passivierende und stabilisierende Substanz (4) eine solche aus der Gruppe der Silikone, z.B. ein Silikonkautschuk, vorgesehen ist.

5. Halbleiterelement nach Anspruch 1, dadurch gekennzeichnet, dass an der Aussenfläche des Isolierkörpers (1) ein bedarfsweise mit einer ringförmigen Erhebung (6a) versehener Überzug (6) zur Erhöhung der Spannungsüberschlagsfestigkeit angebracht ist.

6. Halbleiterelement nach Anspruch 1, dadurch gekennzeichnet, dass der Isolierkörper aus zwei axial aneinander gereihten Teilringen (11, 15) besteht, und dass die Teilringe an ihren inneren Stirnflächen ein zur gemeinsamen Ausbildung einer Vertiefung (14) geeignetes Profil aufweisen.

7. Halbleiterelement nach Anspruch 6, dadurch gekennzeichnet, dass der Isolierkörper zusätzlich zur axialen Justierung der Halbleitertablette (3) vorgesehen ist, dass jeder Teilring (11, 15) des Isolierkörpers an seiner inneren Umfangsfläche einen stufenförmig ausladenden Ansatz (12a, 15a) aufweist und dass die durch den Ansatz vergrösserte, innere Stirnfläche jedes Teilrings mit einem Profil versehen ist, welches eine Aussparung zur Aufnahme der Substanz (4), einen längeren Schenkel an der Aussenmantelfläche zur Verbindung der Teilringe und einen kürzeren Schenkel an der inneren Umfangsfläche zur klammerförmigen, axialen Halterung der Halbleitertablette (3) bildet.

8. Halbleiterelement nach Anspruch 6, dadurch gekennzeichnet, dass jeder Teilring (11) aus zwei axial zusammenfügbaren Teilringabschnitten (12, 13) besteht, und dass zum Einbau in ein Scheibenzellengehäuse mit vorgegebener Bauhöhe nur der innere Teilringabschnitt (12) vorgesehen und entsprechend bemessen ist.

9. Halbleiterelement nach Anspruch 6, dadurch gekennzeichnet, dass jeder Teilring (15) eine Soll-Bruchstelle (16) zur Reduzierung seiner Bauhöhe beim Einbau in ein Scheibenzellengehäuse mit vorbestimmten Gehäusemassen aufweist.

10. Halbleiterelement nach Anspruch 8, dadurch gekennzeichnet, dass der äussere Teilringabschnitt (13) an seiner freien Innenrandzone eine flanschförmige Ausladung (13a) zur Halterung eines Dichtungskörpers zwischen Teilring (12) und einer auf der Halbleitertablette (3) gestapelten Kontaktscheibe aufweist.

11. Halbleiterelement nach Anspruch 1, dadurch gekennzeichnet, dass als Isolierkörper ein bandförmiges Zentrierbauteil (22) mit sich über-

9 0 124 705 10

lappenden Enden vorgesehen ist, die zu ihrer gegenseitigen festen Verbindung durch Einrasten entsprechend ausgebildet sind.

12. Halbleiterelement nach Anspruch 11, dadurch gekennzeichnet, dass die Enden des bandförmigen Zentrierbauteils (22) jeweils aus einem überlappenden inneren Abschnitt (22c, 22d) und aus einem mit diesem eine Klemme bildenden äusseren Abschnitt (24, 26) bestehen, und dass die zum gegenseitigen Eingriff vorgesehenen Klemmen durch Einrasten mit Hilfe von gegenläufig orientierten Einkerbungen (25, 27) festgestellt sind.

13. Halbleiterelement nach Anspruch 1, dadurch gekennzeichnet, dass der Isolierkörper (1) in den an die Vertiefung (2) zur Aufnahme der Randzone der Halbleitertablette (3) angrenzenden Flächenbereichen jeweils eine am Umfang geschlossene Aussparung (7) zur Aufnahme eines Dichtungskörpers (12) aufweist.

14. Halbleiterelement nach Anspruch 1 oder einem der folgenden Ansprüche, dadurch gekennzeichnet, dass der Isolierkörper (1) aus Keramik besteht.

15. Halbleiterelement nach Anspruch 1 oder einem der folgenden Ansprüche, dadurch gekennzeichnet, dass der Isolierkörper (1) aus einem Kunststoff aus der Gruppe der hochtemperaturbeständigen Thermoplaste besteht.

16. Halbleiterelement nach Anspruch 1, dadurch gekennzeichnet, dass zur Durchführung eines Steuerstromleiters (38) im Isolierkörper (1) eine radiale Durchbohrung (5) oder ein in dieser angeordnetes, radial verlaufendes Rohrstück (44) angebracht ist.

17. Halbleiterelement nach Anspruch 1, dadurch gekennzeichnet, dass der im Gehäuseinneren an den Isolierkörper (1) anschliessende Abschnitt des Steuerstromleiters (38) bogenförmig nach Art einer Blattfeder ausgebildet ist, dass im Anschluss daran das gehäuseinnere Ende des Steuerstromleiters zur direkten Kontaktierung der Steuerelektrode der Halbleitertablette (63) eine Krümmung in Form eines Hakens oder einer Öse aufweist und am Ansatz der Krümmung in eine Ebene senkrecht zur Steuerstromleiterachse abgewinkelt und um diese Achse drehbar angeordnet ist.

18. Halbleiterelement nach Anspruch 17, dadurch gekennzeichnet, dass das gekrümmte Ende an seiner Gleitfläche auf der Steuerelektrode der Halbleitertablette (3) zur flächigen Auflage in betriebsbereiter Position plan ausgebildet ist (39).

19. Halbleiterelement nach Anspruch 17, dadurch gekennzeichnet, dass das gekrümmte Ende (38a) kreisbogenförmig ausgebildet ist oder aus mehreren Bogenabschnitten mit unterschiedlichem Krümmungsmittelpunkt besteht.

20. Halbleiterelement nach Anspruch 17, dadurch gekennzeichnet, dass das gekrümmte Ende (38a) aus einem gestreckten Abschnitt und einem beliebig bogenförmigen Endabschnitt besteht.

## Claims

1. Semiconductor device, wherein a semiconductor wafer (3), with control electrode, is encircled by a multi-part insulating body (1) which exhibits a continuous depression (2, 14, 23, 43) on its inner cylindrical surface, this depression enclosing the edge zone of the semiconductor wafer, and wherein the control electrode is maintained in electrical contact with a control current conductor (38) by means of spring pressure, characterized in that

– the depression (2, 14, 23, 43) is essentially matched to the shape of the edge zone of the wafer and is filled with a passivating and stabilizing substance (4),

– the edge zone of the wafer is immersed in the substance filling the depression,

– the substance exhibits the property of being able to adhere to both the semiconductor wafer (3) and the insulating body (1), and

– the control current conductor (38) is led through the insulating body, is shaped, immediately adjacent thereto, as a spring body, and its end section is superposed on the control electrode, under pressure.

2. Semiconductor device according to Claim 1, characterized in that the insulating body (1) consists of n ring-pieces (10), n being not less than 3.

3. Semiconductor device according to Claim 2, characterized in that the n ring-pieces (10) are connected in a chain-like manner, via n-1 flexible prolongations (101), each being formed on the outer surface.

4. Semiconductor device according to Claim 1, characterized in that a substance chosen from the group formed by the silicones is provided as the passivating and stabilizing substance (4), an example of such a substance being a silicone rubber.

5. Semiconductor device according to Claim 1, characterized in that the outer surface of the insulating body (1) is provided with a covering (6) which serves to increase the flashover resistance and which, if necessary, is furnished with a ringshaped bead (6a).

6. Semiconductor device according to Claim 1, characterized in that the insulating body consists of two component rings (11, 15), positioned side-by-side, in axial alignment, and in that the component-ring inner end faces exhibit a profile which is suitable for the joint formation of a depression (14).

7. Semiconductor device according to Claim 6, characterized in that the insulating body is also designed to permit axial adjustment of the semiconductor wafer (3), in that each component ring (11, 15) of the insulating body exhibits a projection (12a, 15a) on its inner circumferential surface, each of which overhangs in the manner of a step, and in that each component-ring inner end face, enlarged by the projection, is furnished with a profile which forms a recess for receiving the substance (4), which further forms a relatively long profile element at the outer cylindrical surface, this element serving to connect the component rings, and which further forms a shorter profile element at the inner circumferential surface, this element serving to hold the semiconductor wafer (3) axially, in a clamp-shaped arrangement.

8. Semiconductor device according to Claim 6, characterized in that each component ring (11) consists of two axially connectable component-ring portions (12, 13), and in that to permit fitting into a presspack case with a specified overall height, only the inner component-ring portion (12) is provided, this inner portion being designed with appropriate dimensions.

9. Semiconductor device according to Claim 6, characterized in that each component ring (15) can be broken at a predetermined location (16), so as to reduce its overall height in the event of its being fitted into a presspack case with predetermined dimensions.

10. Semiconductor device according to Claim 8, characterized in that the outer component-ring portion (13) exhibits a flange-shaped overhang (13a) at its free inner edge zone, this overhang serving to retain a sealing body between the component-ring portion (12) and a contact plate which is superposed on the semiconductor wafer (3).

11. Semiconductor device according to Claim 1, characterized in that a band-shaped centering component (22) is provided as the insulating body, this band-shaped component possessing overlapping ends which are shaped in a manner such that they complement one another, so as to interconnect securely by snapping-in.

12. Semiconductor device according to Claim 11, characterized in that, in each case, the ends of the band-shaped centering component (22) consist of an overlapping inner section (22c, 22d) and an outer section (24, 26) which, with the inner section, forms a grip arrangement, and in that these grip arrangements, which are designed to engage with one another, are locked by snapping-in that is aided by oppositely-oriented serrations (25, 27).

13. Semiconductor device according to Claim 1, characterized in that the insulating body (1) exhibits a continuous circumferential recess (7) in each of the areas adjacent to the depression (2) for receiving the edge zone of the semiconductor wafer (3), this circumferential recess (7) serving to receive a sealing body.

14. Semiconductor device according to Claim 1 or one of the following Claims, characterized in that the insulating body (1) is composed of ceramic material.

15. Semiconductor device according to Claim 1 or one of the following Claims, characterized in that the insulating body (1) is composed of a plastic chosen from the group formed by those thermoplastics which remain stable at high temperatures.

16. Semiconductor device according to Claim 1, characterized in that a radial through-hole (5) is made in the insulating body (1), or a length of tubing (44) is fitted inside this hole (5), running radially, this hole and/or tubing serving as a lead-through for a control current conductor (38).

17. Semiconductor device according to Claim 1, characterized in that the section of the control current conductor (38) inside the case, immediately adjacent to the insulating body (1), is given an arcuate shape resembling a leaf spring, and in that, immediately thereafter, that end of the control current conductor which is inside the case exhibits a hook-shaped or loop-shaped curvature, is bent over, at the beginning of this curvature, into a plane at right-angles to the axis of the control current conductor, and is installed in a manner such that it can rotate about this axis in order to maintain direct electrical contact with the control electrode of the semiconductor wafer (3).

18. Semiconductor device according to Claim 17, characterized in that the curved end is shaped in a manner such that it exhibits a plane area (39) where it slides on the control electrode of the semiconductor wafer (3), this shape being designed to ensure that flat contact occurs in the operational position.

19. Semiconductor device according to Claim 17, characterized in that the curved end (38a) is given a shape corresponding to an arc of a circle, or consists of a plurality of arc sections with different centres of curvature.

20. Semiconductor device according to Claim 17, characterized in that the curved end (38a) consists of a straight section, and an end section which may be of any desired arcuate shape.

**Revendications**

1. Dispositif semi-conducteur dont une plaquette semi-conductrice (3) comportant l'électrode de commande est enveloppé par un corps isolant (1) en forme d'anneau et à plusieurs parties, qui présente sur sa paroi annulaire intérieure un évidement fermé sur lui-même (2), (14), (23), (43) enveloppant la zone périphérique de la plaquette semi-conductrice, l'électrode de commande étant mise en contact par un conducteur de commande (38) grâce à un effet de ressort, caractérisé en ce que:

– l'évidement (2), (14), (23), (43) qui présente une forme adaptée à celle de la zone périphérique de la plaquette semi-conductrice est rempli d'une matière (4) passivante et stabilisante,

– la zone périphérique de la plaquette semi-conductrice est engagée dans ladite rembourrure en matière passivante et stabilisante,

– la matière présente des propriétés d'adhérence sur la plaquette semi-conductrice (3) et le corps isolant (1),

– le conducteur de commande (38) qui traverse le corps isolant, se présente sous forme d'un ressort à la sortie dudit passage à travers le corps isolant et exerce une pression, par son segment d'extrémité, sur l'électrode de commande.

2. Dispositif semi-conducteur selon la revendication 1 caractérisé en ce que le corps isolant (1) se compose de n segments annulaires (10), n étant égal ou supérieur à 3.

3. Dispositif semi-conducteur selon la revendication 2 caractérisé en ce que les n segments annulaires (10) sont assemblés en une chaîne par (n-1) charnières souples (101), disposées sur la paroi extérieure desdits segments.

4. Dispositif semi-conducteur selon la revendication 1 caractérisé en ce que la matière passivante et stabilisante (4) appartient au groupe des silicones et est par exemple du caoutchouc-silicone.

5. Dispositif semi-conducteur selon la revendication 1 caractérisé par un revêtement (6) prévu sur la paroi extérieure du corps isolant (1), comportant en tant que de besoin une saillie ou bourrelet annulaire (6a), servant à accroître la résistance au contournement.

6. Dispositif semi-conducteur selon la revendication 1 caractérisé en ce que le corps isolant se compose de deux parties annulaires (11), (15) assemblées axialement, comportant chacune sur sa surface frontale intérieure une conformation adaptée pour déterminer ensemble un évidement (14).

7. Dispositif semi-conducteur selon la revendication 6 caractérisé en ce que:
– le corps isolant sert de plus à l'ajustement axial de la plaquette semi-conductrice (3),
– chaque partie annulaire (11), (15) du corps isolant comporte sur sa paroi intérieure un étagement sous forme d'une saillie (12a), (15a),
– la surface frontale intérieure de chaque partie annulaire, prolongée par ladite saillie, présente un évidement destiné à la réception de la matière (4), dont le flanc de plus long, situé du côté de la paroi extérieure, permet l'assemblage des deux parties annulaires et dont le flanc le plus court, situé du côté de la paroi intérieure, sert au maintien axial par pincement de la plaquette semi-conductrice (3).

8. Dispositif semi-conducteur selon la revendication 6 caractérisé en ce que chaque partie annulaire (11) se compose de deux sous-anneaux (12), (13) pouvant être assemblés axialement et en ce que seul le sous-anneau (12) intérieur est prévu et dimensionné de façon correspondante pour le montage dans le boîtier de cellule-disque à hauteur prédéterminée.

9. Dispositif semi-conducteur selon la revendication 6 caractérisé en ce que chaque partie annulaire (15) comporte une pré-entaille de rupture (16) afin de pouvoir réduire la hauteur de construction en vue d'une intégration dans un boîtier de cellule-disque de dimensions prédéterminées.

10. Dispositif semi-conducteur selon la revendication 8 caractérisé en ce que le sous-anneau extérieur (13) comporte dans la zone périphérique de sa paroi intérieure une saillie (13a) destinée au maintien d'un corps d'étanchéité entre le sous-anneau (12) et d'un disque de contact empilé sur la plaquette semi-conductrice (3).

11. Dispositif semi-conducteur selon la revendication 1 caractérisé en ce que le corps isolant est constitué par un élément de centrage (22) en forme de bande avec des extrémités se chevauchant et conformées de façon à permettre un assemblage stable par engagement réciproque.

12. Dispositif semi-conducteur selon la revendication 11 caractérisé en ce que les extrémités de l'élément de centrage (22) en forme de bande sont subdivisées chacune en un segment intérieur (22c), (22d) se chevauchant l'un l'autre, et, un segment extérieur (24), (26) constituant une mâchoire avec le segment intérieur, lesdites mâchoires étant bloquées par un engagement réciproque grâce à des entailles (25), (27) opposées.

13. Dispositif semi-conducteur selon la revendication 1 caractérisé en ce que le corps isolant (1) comporte, dans chacune des zones adjacentes à l'évidement (2) destiné à la réception de la zone périphérique de la plaquette semi-conductrice (3), un évidement (7) fermé sur lui-même, destiné à la réception d'un corps d'étanchéité (12).

14. Dispositif semi-conducteur selon l'une des revendications 1 à 13 caractérisé par un corps isolant (1) en céramique.

15. Dispositif semi-conducteur selon l'une des revendications 1 à 14 caractérisé par un corps isolant (1) en une matière synthétique du groupe des matières thermoplastiques stables à des températures très élevées.

16. Dispositif semi-conducteur selon la revendication 1 caractérisé en ce que le passage du conducteur de commande (38) à travers le corps isolant (1) est assuré par un trou radial (5) ou une douille radiale (44) disposée dans ledit trou.

17. Dispositif semi-conducteur selon la revendication 1 caractérisé en ce que:
– le segment du conducteur de commande (38) prolongeant à l'intérieur du boîtier le premier segment traversant le corps isolant (1), présente une courbure à l'instar d'une lame de ressort,
– l'extrémité du conducteur de commande prolongeant le second segment à l'intérieur du boîtier et permettant l'établissement direct du contact de l'électrode de commande de la plaquette semi-conductrice (3), est recourbée pour prendre la forme d'un crochet ou œillet, est repliée à la jonction avec le second segment dans un plan perpendiculaire à l'axe du conducteur de commande, et est mobile autour dudit axe.

18. Dispositif semi-conducteur selon la revendication 17 caractérisé en ce que la surface de glissement de l'éxtrémité recourbée sur l'électrode de commande de la plaquette semi-conductrice (3) est plane en vue de ménager une surface d'appui (39) en position prête au fonctionnement.

19. Dispositif semi-conducteur selon la revendication 17 caractérisé en ce que l'extrémité recourbée (38a) a une forme d'arc de cercle ou se compose de plusieurs segments de cercle successifs avec des centres de courbure différents.

20. Dispositif semi-conducteur selon la revendication 17 caractérisé en ce que l'extrémité recourbée (38a) se compose d'un segment allongé et d'un segment extrême recourbé à la demande.

# Fig.1

5

38

38a

4

2

6a

3

6

1

21  7

# Fig.2

7'

2

10

101

10

10

7

2

7

2

10

101

**Fig.3a**

**Fig.3b**

**Fig.4a**

**Fig.4b**

0124705

Fig.5

Fig.6

13